# EUROPEAN PATENT SPECIFICATION

(11) **EP 0 287 838 B1**
(45) Date of publication and mention of the grant of the patent: **06.10.1993**
(21) Application number: 88104776.5
(22) Date of filing: 24.03.1988
(51) Int. Cl.: H01L 21/00

(54) **An apparatus for transporting an electrically conductive wafer**
Eine Vorrichtung zum Transport eines elektrisch leitenden Wafers
Un dispositif pour le transport d'une puce électriquement conductrice

(30) Priority: 31.03.1987 JP 80368/87
(43) Date of publication of application: 26.10.1988
(73) Proprietor: FUJITSU LIMITED, Kawasaki-shi, Kanagawa 211 (JP)
(72) Inventor: Machida, Akira, Kawasaki-shi Kanagawa, 211 (JP)
(74) Representative: Schmidt-Evers, Jürgen, Dipl.-Ing.

(56) References cited:
- EP-A- 0 102 569
- DE-B- 1 131 595
- FR-A- 2 554 250
- US-A- 4 624 617

## Description

This invention is related to an apparatus for transporting an electrically conductive material having a shape of wafer by the use of electro-static attractive force.

### Description of the Related prior Art

There have been many types of carrying mechanism employed for transporting a wafer, which is relatively light weighted, such as a semiconductor wafer. Some of the conventional transporters are shown in FIG. 1 through FIG. 5. FIG. 1 shows a belt conveyer system where a wafer to be carried is placed on a belt which is driven by a motor, a driver mechanism. FIG. 2 and 3 show a so-called walking beam system where the beam makes a square motion like a fork lift, i.e. the beam moves along the arrow mark "a" to lift the wafer 6 sitting on a stage, then transports the wafer horizontally along the arrow mark "b", goes down along the arrow mark "c" to leave the wafer on the stage and returns along the arrow mark "d" to the original position. FIG. 4 shows an air bearing system where an air jet is blown off from a plurality of air nozzles provided in the stage by which the wafer is to be transported, and angle of direction of the air jet is slanted so that the wafer is floated as well as driven toward the destination. In the opposite way air is used to attract an object. The FR-A-2554250 discloses a chuck which holds a wafer by vacuum force.

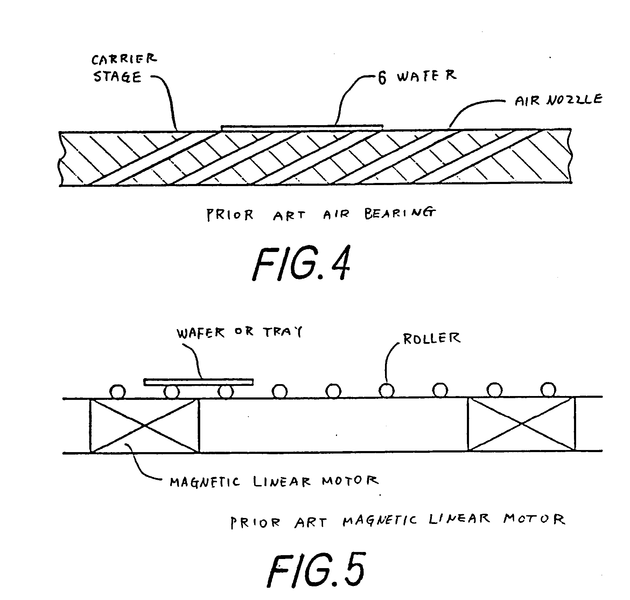

FIG. 5 shows a linear motor system as disclosed in the US-A-4624617, where a car comprising magnets carries the wafer (or anything else) thereon. The wafer necessarily is in contact with the surface of this car which is magnetically driven by said linear motor system.

The EP-A-0102569 discloses a device for transporting dielectric powder materials in a horizontal direction, but this material may also be a sheet. This device is also composed of a plurality of plane electrodes, each of said electrodes having a plane surface horizontally coplanar with each other, said plane surface of said electrodes facing the dielectric material to be transported and the material is transported. In order that no powder will remain on the surface of the electrodes this powder is blown away from these electrodes. Therefore nozzles are provided in these electrodes through which air is blown.

A so-called electro-static chuck is disclosed in the JP-A-57-64950. This chuck is composed of plural flat electrodes covered with a dielectric layer, and a high voltage is applied between the electrodes. An electro-static attractive force induced between the wafer and the electrodes by the applied voltage holds the wafer.

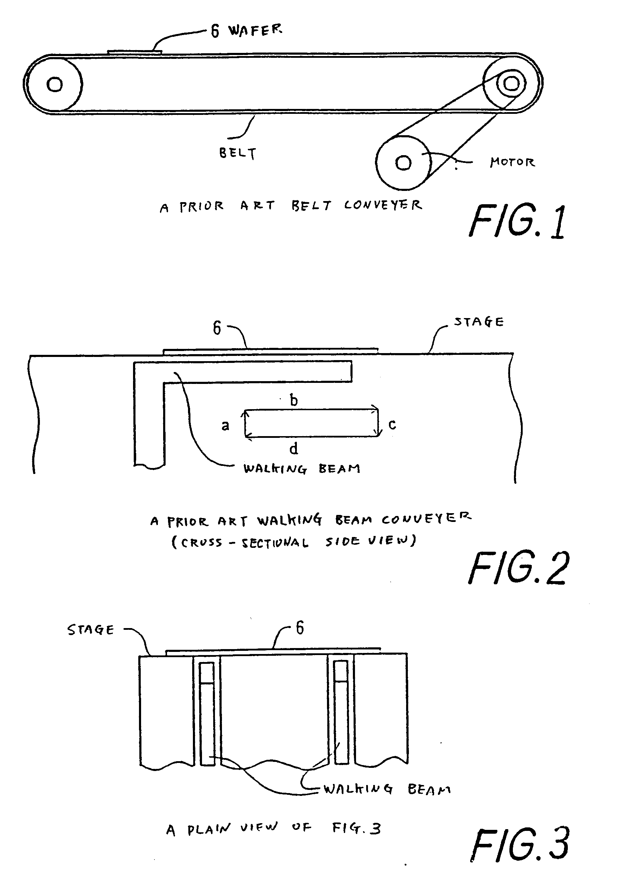

Problems of these conventional systems are as follows:
In the systems of FIG. 1 through 3 and the above electro-static chuck, the surface of the wafer must contact a foreign material, such as the belt, the beam, the dielectric layer, etc., and the system becomes bulky. In FIG. 4 the edges of the electrodes must contact side walls (which are not shown in FIG. 4), by which the wafer is guided, i.e. is prevented from deviating from its direction. In FIG. 5 the wafer or a tray must be of a magnetic material and the mechanism becomes complicated, but the semiconductor wafer, now in a major consideration, is not magnetic. Further more, there are problems that the mechanically moving parts are apt to deliver dust or an impurity material which are harmful for the semiconductor production. Machining of the slanted air bearing nozzles requires very sophisticated technique causing an increase of the cost of the production facilities. Further more, either of these conventional systems consumes a considerable amount of electric power.

### SUMMARY OF THE INVENTION

It is an object of the invention to provide a wafer transporting system which has no mechanically moving parts and which can transport a semiconductor wafer whose fabricated surface is facing down without touching anything (but air). This system shall be free from dust, harmful gas or deposition and contamination. This wafer transporting system shall consume only little power.

This object is achieved by the features of claim 1.

According to the present invention, a wafer transporter is composed or a plurality of plane electrodes arranged horizontally and coplanarly with each other so as to vertically face the wafer to be transported. A DC (direct current) voltage is applied between the electrodes so that the wafer, which is electrically conductive, is electro-statically attracted vertically toward the voltage-applied electrodes by an induced electric polarization charge on the wafer. The surfaces of the electrodes facing the wafer are provided with air nozzles through which air is blown off to repulse the wafer not to directly contact the electrodes. Therefore, the air gap between the wafer and the electrodes' surface is kept at the balancing of the vertically attractive force and the air repulsion force. On the other hand, unbalance in the electrode's area facing the wafer also produces an electro static attractive force horizontally on the wafer. Because of no friction between the wafer and the electrodes, the horizontally attractive force easily moves the wafer in a horizontal direction. If the wafer is to be continuously accelerated toward the horizontal direction, the voltage application is sequentially switched to a new electrode. Therefore, a horizontal wafer transporter is achieved without contacting anything but air, keeping the fabricated semiconductor surface downward, without requiring any movable mechanism and consuming little power. The electrode's surface may be coated with a dielectric layer to prevent direct contact of the wafer to the electrode.

The above-mentioned features and advantages of the present invention, together with other objects and advantages, which will become apparent, will be more fully described hereinafter, reference being had to the accompanying drawings forming a part hereof, wherein like numerals refer to like parts throughout.

### BRIEF DESCRIPTION OF THE DRAWINGS

FIG. 1 schematically illustrates a side view of a prior art transporter system employing a belt conveyer.

FIG. 2 schematically illustrates a side view of a prior art transporter system employing a walking beam.

FIG. 3 schematically illustrates a plain view of the prior art transporter system of FIG. 2.

FIG. 4 schematically illustrates a side view of a prior art transporter system employing slanted air nozzles.

FIG. 5 schematically illustrates a prior art transporter system employing a magnetic linear motor.

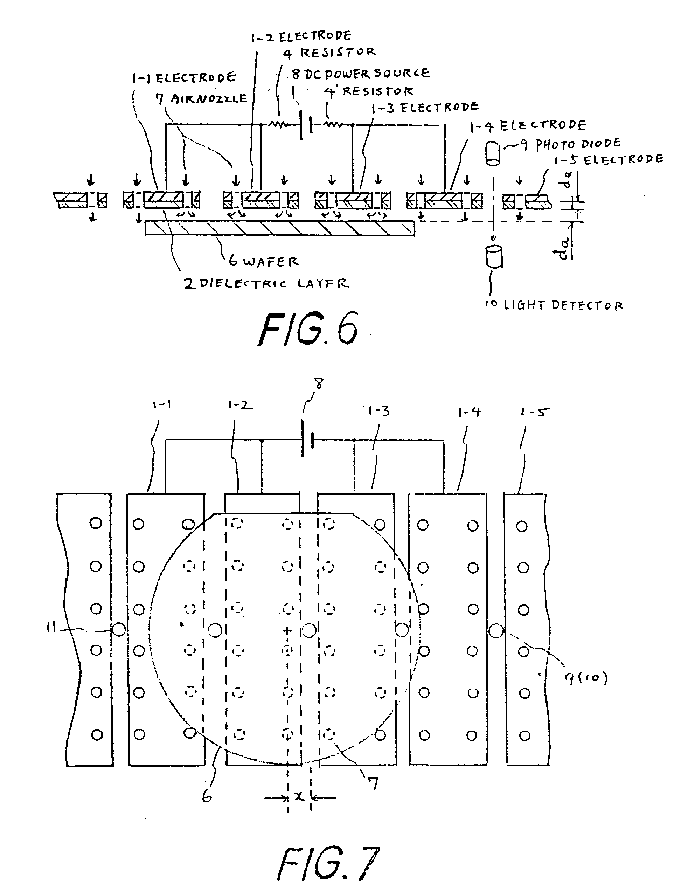

FIG. 6 schematically illustrates a sectional side view of an embodiment of the present invention.

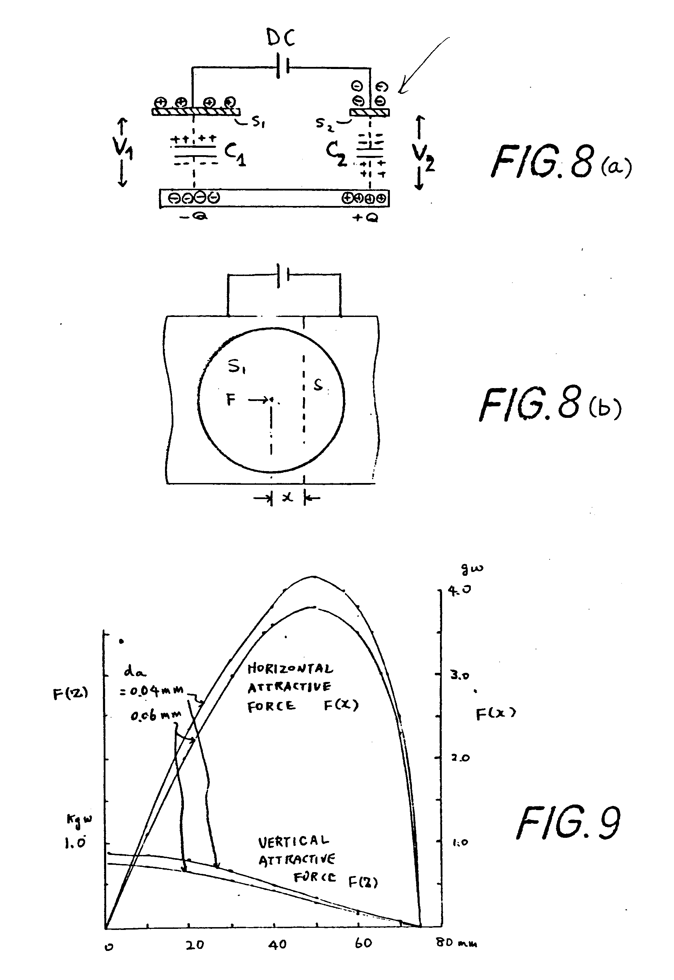

FIG. 7 schematically illustrates a plain view of an embodiment of the present invention shown in FIG. 6.

FIG. 8(a) shows an equivalent electrical circuit diagram of the present invention.

FIG. 8(b) shows a simplified model configuration of the electrodes and the wafer for theoretical analysis of the electro-static attractive forces of the present invention.

FIG. 9 shows the horizontal attractive force and the vertical attractive force as functions of the wafer location with respect to the electrodes.

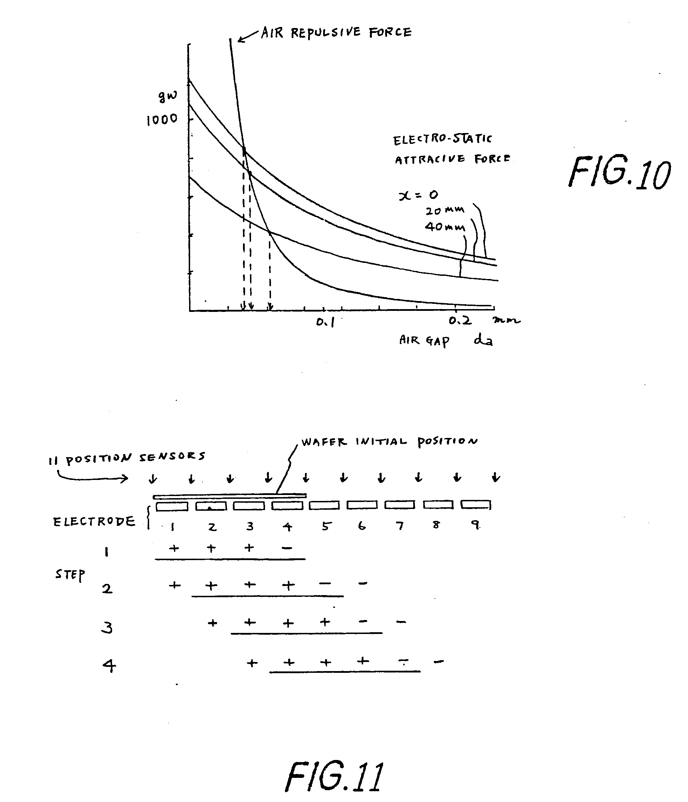

FIG. 10 shows the vertical attractive force and the repulsive force as functions of the air gap.

FIG. 11 schematically illustrates switching sequence of the voltage application to the electrodes for a continuous acceleration.

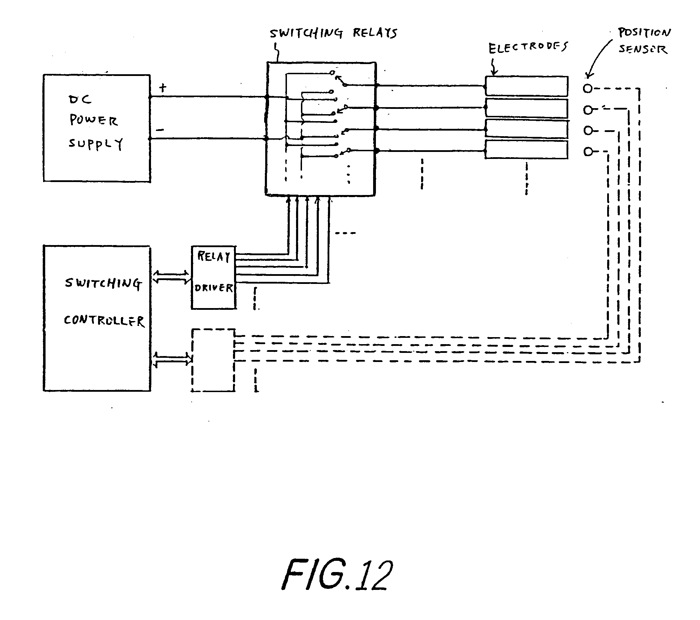

FIG. 12 schematically illustrates switching circuits for the voltage application to the electrodes.

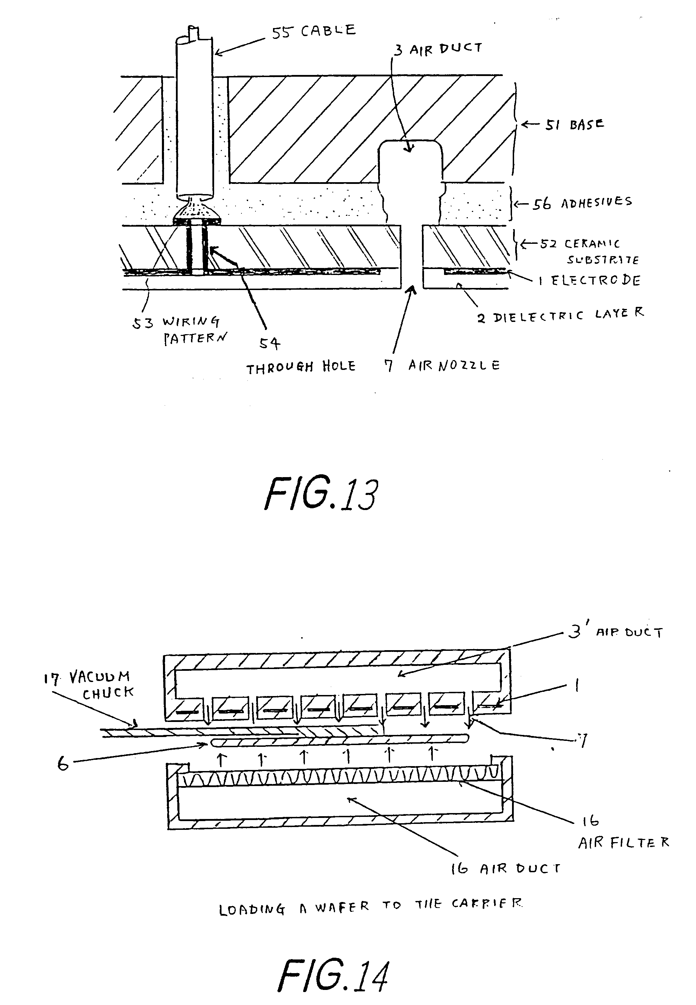

FIG. 13 shows a cross-sectional view of a practical structure of a typical wafer transporter according to the present invention.

FIG. 14 shows a cross-sectional view orthogonal to the direction of the wafer transportation at a loading/unloading stage.

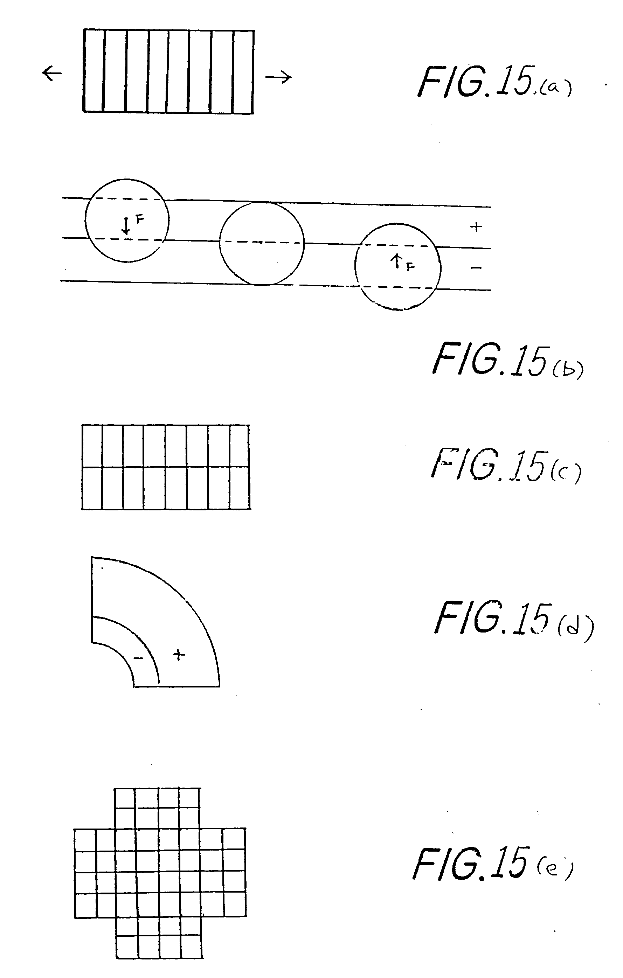

FIGs. 15 schematically illustrate the variation of electrode's configurations.

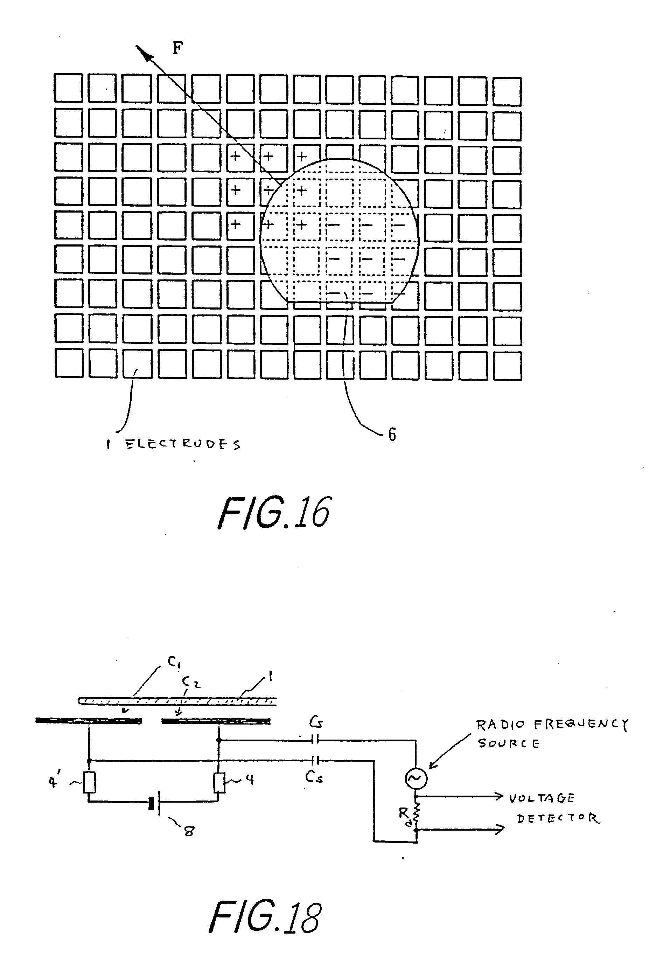

FIG. 16 shows an example of voltage application for moving the wafer in a diagonal direction.

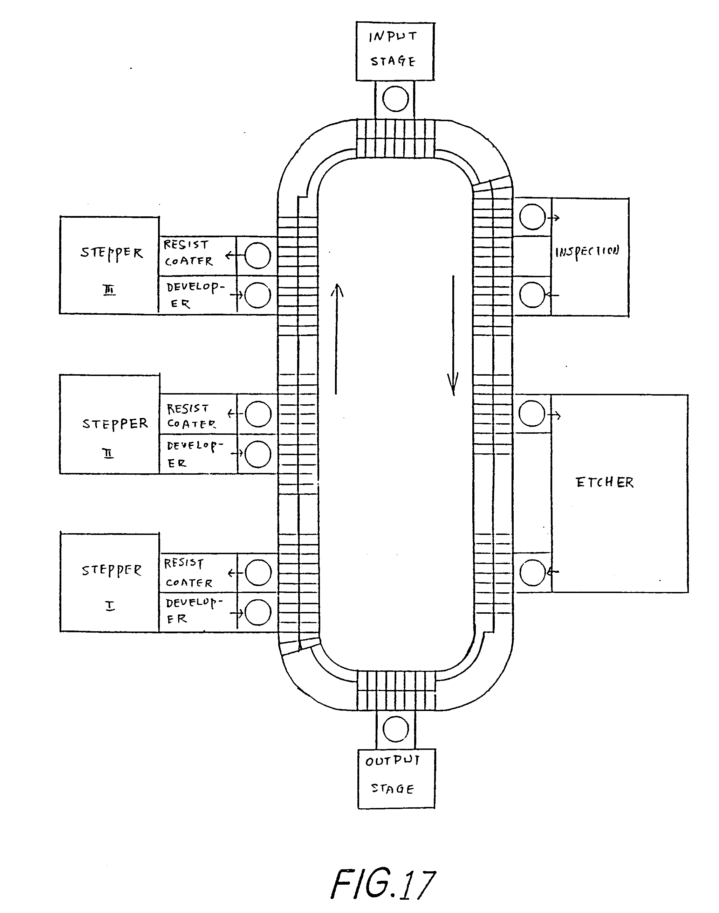

FIG. 17 schematically illustrates an example of the electrodes layout in a semiconductor production system.

FIG. 18 shows the principle of a position sensor using a radio frequency.

### DESCRIPTION OF THE PREFERRED EMBODIMENTS

Referring to FIG. 6 and 7, the principle of the present invention is hereinafter described. Plane electrodes 1-1 through 1-5 are provided horizontally coplanar with each other, in a transporter stages which is not shown in FIG. 6. A semiconductor wafer 6, which can be considered to be electrically conductive in this invention, is located to face the electrodes 1-1 through 1-4, and in this embodiment the wafer is located below the electrodes. The electrodes's surfaces facing the wafer are coated with a dielectric layer 2, such as alumina ceramic, as thick as 2.0 mm, for example. Through the electrodes 1 as well as the dielectric layer 2 thereon there are provided many air nozzles 7 through which a clean dry air is blown off vertically and perpendicularly towards the wafer 6. Grid pitch of the nozzles is 10 to 20 mm, for example, for a 6 inch wafer. The blowing air is supplied from through an air duct 3, which is not shown in FIG. 6 and 7 but shown in FIG. 14, into the nozzles 2. A positive polarity of a DC 5,000 volt is applied preferably via a resistor 4 to the electrodes 1-1 and 1-2 from a DC power source 8, and the negative polarity of the same DC 5,000 volt is applied preferably via a resistor 4ʹ to the electrode 1-3 and 1-4. Equivalent electrical circuit diagram of this state is shown in FIG. 8(a), where C₁ shows an equivalent capacitor between the wafer and the electrodes 1-1 and 1-2, to which the positive terminal is connected and C₂ shows an equivalent capacitor between the wafer and the electrodes 1-3 and 1-4, to which the negative terminal is connected. Capacitance value of these capacitors C₁ and C₂ vary depending on the horizontal and vertical location of the wafer with respect to the electrodes. The DC voltage applied to the electrodes induces polarized electric charge on the wafer as shown in FIG. 8, consequently induces voltages V₁ across the capacitor C₁ and voltage V₂ across the capacitor C₂. In other words, the series circuit consist of C₁ and C₂ divides the applied voltage 2,00 V into V₁ and V₂ via the wafer. These voltages V₁ and V₂ induced between the wafer and the electrodes produces an electro-static attractive force which pulls the wafer vertically toward the electrodes. However, the air blowing off from the nozzle repulses the wafer so as to prevent the wafer from contacting the electrodes. Gap between the electrodes and the wafer is determined as a result of balance of the attractive force toward the electrodes and the repulsive force of the blowing air. Details of this balancing is explained later. Thus, the wafer can float in an air keeping a proper distance from the electrodes, accordingly there is no friction therebetween. On the other hand, there is a general rule that C₁V₁=Q=C₂V₂ because the induced charge Q is common for both the capacitors C₁ and C₂, thus V₁:V₂=C₂:C₁. Now C₁ is larger than C₂, therefore, V₁ is lower than V₂. The voltage difference between V₂ and V₁ produces a horizontal attractive force towards higher voltage side, i.e. right hand side in this example, as shown by the arrow mark F in FIG. 8(b). Because of no friction as mentioned above, the wafer is moved toward the horizontal direction. When C₁ becomes equal to C₂, V₂ becomes equal to V₁, then the horizontally attractive force becomes zero. Thus, the wafer is always forced to move to the balance point where the area S₁ and S₂ is equal, regardless of whether the polarity of x indicating the present location of the wafer is plus or minus.

Theoretical analysis of the attractive forces in detail is as follows: Now defined that the capacitance C₁ and C₂ are formed of the area S₁ and S₂ respectively. Thickness and the dielectric constant of the dielectric layer 2 are dₑ and Eᵣ, respectively. Gap between the wafer and the surface of the dielectric layer 2 is dₐ. Then, C₁ and C₂ are obtained as follows:

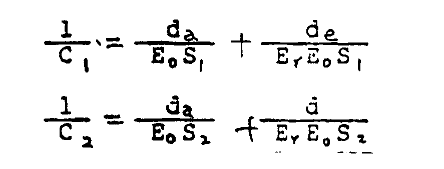

Therefore, the overall capacitance C, which is the load of the DC power source, is the series capacitance of C₁ and C₂ shown by the following formula:

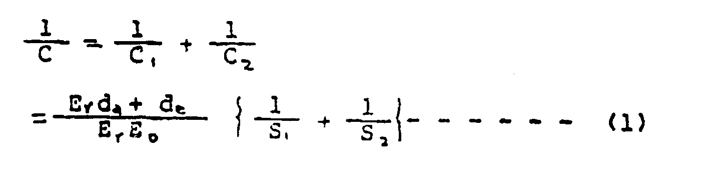

Now the overall electro-static potential energy U is shown by the following formula, where V is the DC voltage applied from the power source:

$\text{U = ½ CV² (2)}$

On the other hand, as a general rule of dynamics, a force is induced in an amount as well as in a direction that the potential energy U is to become less. Each of the x, y and z component of the force are represented by the following formula, where x, y and z represent orthogonally horizontal direction and vertical direction respectively:

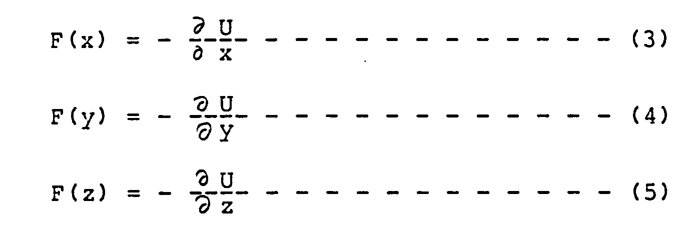

The formulas (3), (4) and (5) are further reduced with the formulas (1) and (2) as follows:

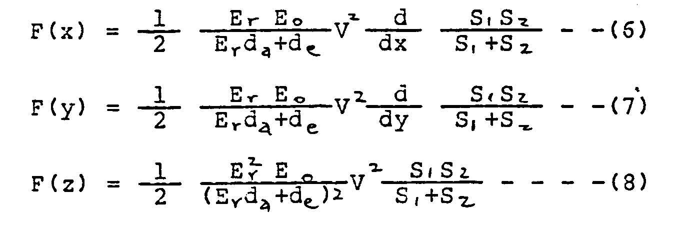

F(z) is a total force of areas S₁ and S₂ pulling the wafer towards the electrodes. F(x) and F(Y) act as the forces to move the wafer horizontally toward x and y directions respectively. In the model case where the wafer is round as shown in FIG. 8(b), where "x" is defined as a location of the centre of the wafer measured from the border line of two electrodes to which the opposite polarities of the power source are applied to respectively, the calculation of the variable part of F(x) is resulted in:

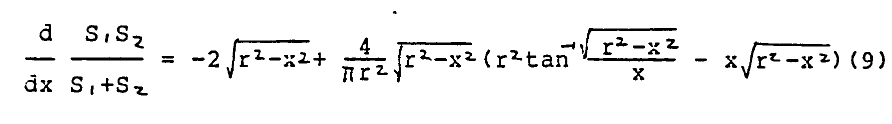

The result of the quantitative analysis of a round wafer, having no orientation flat as shown in FIG. 8(b), on a horizontal attraction force and vertical attractive force are shown in FIG. 9, where:

| | |
|---|---|
| Radius of the wafer (6" dia.) | 75 mm |
| Width of the electrodes (W) | 16 cm |
| Pitch of the electrode along its direction(L) | 2 cm |
| Applied voltage from a power source | 5,000 V DC |
| Gap between the wafer and surface of dielectric layer on the electrode (dₐ) | approx. 50 µm |
| Thickness of the dielectric layer (dₑ) | 2.0 mm |
| Dielectric constant of the dielectric layer | 10 |

On the other hand, the repulsive force produced by the air blow is shown in FIG. 10 as a function of the air gap dₐ, where:

| | |
|---|---|
| Diameter of nozzles | 1 mm |
| Pitch of a square grid of the nozzles | 20 mm |
| Total number of the nozzles facing the wafer | 44 |
| Velocity of the blowing air | 4.0 m/s |

The amount of the air gap dₐ falls on the balancing point where the attractive force F(z), copied from FIG. 9, and Fp (=the repulsive force Fr + the weight of the wafer) become equal as shown by an intersectional point of the two curves F(z) and FPM in FIG. 10. The repulsive force sharply decreases on the increase of the air gap dₐ. Shape of these curves vary depending upon the value of the applied voltage, dielectric constant and the thickness of the dielectric coat, the velocity of the air blow, the number of nozzles and the diameter of the nozzles. Consequently, the two curves can be designed so that they intersect each other at a proper air gap, 40 µm for x=0, 45 µm for x=20 mm and 60 µm for x=40 mm as seen in FIG. 10, at which conditions the horizontal acceleration is also properly achieved as is explained later. To simplify the explanation, total attractive force of S₁ and S₂ is used for F(z), however, in the practical designation it must be considered that the vertical attractive force is not equal on the different areas S₁ and S₂.

From the results shown in FIG. 9 it is observed that in the range of "x" = 20 to 40 mm, at least 2.2 gw (gram weight) of horizontal acceleration is obtained, while at least 450 gw of vertical attractive force is obtained.

When the wafer is required to be moved, i.e. to be accelerated, further in the case of FIG. 9, the voltage application onto the electrode must be switched, at the moment when the amount of "x" reaches approximately 20 mm, to a new electrode whose edge is then located at approximately 40 mm. Details of the manner of this switching will be described later.

As observed in FIG. 9, an average value of F(x) for the range x=20 through 40 mm is 3.0 gw. A semiconductor wafer of 6 inch diameter, and 700 um thick weighs approximately 30 grams. Therefore, this wafer is accelerated by 0.10 G (which is 3.0 divided by 30). Thus, after being accelerated along a 500 mm travel, speed of the wafer reaches as high as 1.0 m/sec. After the wafer is once accelerated the wafer keeps on moving by its inertia even without external acceleration force, because of no friction of the wafer. Therefore, when the wafer is to be stopped somewhere, the wafer must be decelerated. The principle of the deceleration is the same as that of the acceleration except the direction of the produced horizontal attractive force is opposite. Transportation of the wafer for 500 mm distance, i.e. 250 mm acceleration and 250 mm deceleration, is achieved by 1.4 second.

Details of the switching of the voltage application to the electrodes for a continuous is hereinafter described. FIG. 11 shows the manner of the change of the applied voltages onto each electrode as the wafer travels along the row of the electrodes. The horizontal sequence in FIG. 11 indicates the numbering of the electrodes, and the vertical sequence indicates the advance of time by steps during each of which the wafer advances to pass by a single electrode. To simplify the drawing the number of the electrodes simultaneously facing the wafer is chosen four in FIG. 11. The cross-sectional view of the wafer is at the initial state in which the wafer is facing the four electrodes 1 through 4. The "+" or "-" marks in FIG. 11 indicate that the plus or minus voltage is applied to the electrode existing there. The underline beneath "+" and "-" marks indicates the location of the wafer with respect to the electrodes at each step. The arrow marks ↓↓ indicate locations of position sensors, each of which is, in this example, formed of a photo coupler. This photo coupler is composed of a photo diode 9 and a light detector 10 (FIG. 6). A light emitted from the photo diode 9 is received, thus detected, by the light detector 10. As well known, an interception of the light transmission in the photo coupler by the wafer induces an electrical signal indicating the existence of the wafer. In FIG. 11, the photo couplers 11, i.e. the position sensors, are located at the border lines of neighbouring two electrodes. A transition of the signal from the position sensor initiates switching the voltage application. To simplify the drawing, only one set of the position detector 9 and 10 is shown in FIG. 6 as a representative of other position sensors 11 (not shown in FIG. 6 but shown in FIG. 7) located at each border line of the electrodes. The switching circuit is schematically illustrated in FIG. 12, where the switching is carried out according to a pre-programmed schedule given by a switching controller including a micro computer. Switching of each electrode is carried out by means of an electro-mechanical relay because of its high handling voltage. As described earlier, the wafer is always attracted toward a direction in which side the quantity of the voltage-applied electrodes is less than that of the opposite side, accordingly in FIG. 11 the wafer is continuously accelerated toward the right hand side. The position sensor 11 can be located at another place than that of FIG. 6 and 7, depending on the total design consideration. As described above, the switching, particularly its timing, of the electrodes on the front side of the wafer is essential, but the timing of the switching of the electrodes on the rear side is not so essential.

The practical structure of the electrodes are shown in FIG. 13. Upon one side of a ceramic substrate 52, already having air nozzles 7 therethrough, the electrodes 1 are patterned, on the other side of the substrate a wiring 53 is patterned, and also through-holes 54 are formed to connect the patterns 1 and 53 by the widely used IC technique. A dielectric layer 2 is coated on the electrodes as well as the ceramic surfaces. The wiring pattern 53 is led out by a cable 55, which is soldered to the pattern 53. The substrate 52 together with the cable is glued to an aluminum base 51 by means of an adhesives 56, while an air duct 3 is formed behind the air nozzles 7.

A cross-sectional view of the system as an embodiment of the invention is shown in FIG. 14, which also shows an example of loading the wafer to the system of the invention, by a cut orthogonal to the direction of the wafer transportation. An air filter 16 is provided underneath the course of the wafer travel. The air filter 16 supplies a clean air into the system and also functions to support the wafer when the wafer falls from the transporter. The wafer may be once placed on the filter 16 by some means, such as the vacuum chuck 17 from a previous stage or conveyer, then the air is blown off from the filter 16 strongly enough to push up the wafer to a zone at which the vertical attractive force of the electrodes 1 is effective.

There can be many types of electrode configurations depending on each purpose. Some of the typical electrode configurations are summarized in FIG. 15(a) through 15(e), where the arrow marks indicate the horizontal electro-static force imposed onto the wafer by the invention. FIG. 15(a) is for a linear acceleration, deceleration or holding of the wafer. FIG. 15(b) is for a linear constant-speed transportation, but the wafer is forced to keep the centre line of the travel course without any acceleration or deceleration toward the direction of the transportation. FIG. 15(c) is a combination of FIG. 15(a) and (b). FIG. 15(d) is for a curved course, without any acceleration or deceleration toward the direction of the transportation, where the wafer is guided to keep the curved travel course. FIG. 15(e) is for orthogonally branching the course of the wafer transportation. With the electrode configuration and the voltage application thereto shown in FIG. 16, an arbitrary direction of the wafer transportation, such as a diagonal direction indicated by the arrow mark F, can be chosen by designing the combination of the voltage application on the electrodes as shown by the "+" and "-" marks denoting the positive and negative voltage application respectively thereto, thus is applicable also for branching the course of the transportation. In the application of FIG. 15(b) and (d), unless the factors, such as the speed of the wafer at the entrance thereto, the weight of the wafer, the applied voltage, and the curvature of the curve, are carefully selected for determining the electrode configuration of the curved course, the wafer may step out of the course or laterally oscillates while traveling there-along. When the width A is larger than the width B in FIG. 15(d), the initial wafer speed at the entrance of the curved course can be chosen higher. An entire electrode layout for a typical wafer carrier system used for the semiconductor wafer processing is shown in FIG. 17.

In the above-described system, the wafer is located below the electrodes, i.e. pulled up by the electrode, then the surface of the wafer on which semiconductor devices are already fabricated must face downward, i.e. the fabricated surface should not face the electrodes, so that the fabricated elements thereon can be protected from a high voltage electrical field induced thereon from the electrodes' voltage. This facing down posture is advantageous to avoid undesirable deposition of harmful particles thereon.

The total capacitance as a load of the applied DC voltage is, for example, 10 pf for a single switching, accordingly the charging current, for example 10 switchings per 0.5 sec, is as low as 2 µA. Therefore power consumption is of the order of 10 mW, which is negligibly small compared with those of the conventional systems.

Though in the above-described embodiment the wafer is in a posture so as to be pulled up by the electrodes, it is obvious that the wafer can be located above the electrodes whose surfaces are facing upward and the air is blown off upward as well. In this case, the air gap is, of course, determined by the balance of the repulsive force of the air blow and (the vertical attractive force + the wafer's weight).

Though in the above-described embodiment the transported object is a semiconductor wafer, any other object can be transported by the system of the invention, as long as the object is electrically conductive and it has a flat surface but light in weight. Electrical conductivity of the wafer can be of a high resistive material, such as a silicon wafer for semiconductor production, because the charging current flowing through the wafer is very small thus the induced voltage drop across the wafer is negligibly small compared with the the total supply voltage. An insulating material, such as ceramic substrate, can be transported by this system if its surface is coated with an electrically conductive material, such as copper layer.

Though in the above-described embodiments the voltage applied onto the electrodes is a DC voltage having a particular polarity, however, the voltage polarization can be reversed, or may be replaced by an AC voltage as long as the the voltage insulation, the attractive forces and the power consumption is allowable.

Though in the above-described embodiment the position sensor is explained referring to a photo coupler, the position sensor may be of an RF (radio frequency) method, in which an RF signal voltage is applied between two electrodes as shown in FIG. 18 and also disclosed by Abe et al in unexamined patent application No. Tokukai Sho57-108264. An RF current flowing onto the two electrodes increases when the wafer comes to face the two electrodes to which the voltage is applied. In FIG. 18, the resistors 4 and 4ʹ are for blocking the RF current flowing into the power supply circuit. The resistors 4 (4ʹ) may be replaced by an inductive elements. Impedance of the resistors or the inductive elements must be high enough at the applied RF frequency compared with the impedance of the capacitance C₁ or C₂. In FIG. 18, the current is detected by measuring the voltage drop induced across a resistor Rd by the flowing current thereto. Thus, an increased state of the RF current indicates an existance of the wafer, i.e. the wafer position.

## Claims

1. An apparatus for transporting a sheet material in a horizontal direction, said device comprising
a plurality of plane electrodes (1-1, ..., 1-5), each of said electrodes having a plane surface horizontally coplanar with each other, said plane surface of said electrodes (1-1, ..., 1-5) facing said material, and
first means for selectively applying a voltage to at least one of said electrodes (1-4) and an opposite voltage to the others of said electrodes (1-1, 1-2, 1-3) in accordance with a predetermined sequence, thus excerting a force on the material in the horizontal direction according to which force said material is transported horizontally,
characterized in that
- said material is an electrically conductive material wafer (6),
- so that said conductive wafer (6) is attracted by said applied voltages also in a vertical direction towards said electrodes, and
- second means are provided for blowing gas to maintain an air gap between said electrodes (1-1, ..., 1-5) and said wafer (6) by balancing a resulting vertical force which is due to the weight of the conductive wafer and said vertical attraction towards said electrodes caused by said applied voltages.

2. An apparatus according to claim 1, characterized in that said second means comprises a plurality of gas nozzles (7) installed through the surfaces of said plane electrodes (1-1,...1-5), through said nozzles (7) the gas being blown off perpendicularly toward the wafer (6).

3. An apparatus according to claim 2, characterized in that said gas is selected from a group of an inert gas and a clean dry air.

4. An apparatus according to any one of claims 1 to 3, characterized in that said surfaces of said plane electrodes (1-1,...1-5) are covered with a dielectric layer (2).

5. An apparatus according to any one of claims 1 to 4, characterized in that said voltages applied to said electrodes 1-1,...1-5) are DC (direct current) voltages.

6. An apparatus according to any one of claims 1 to 5, characterized in that the number of said plane electrodes (1-1,...1-5) to which said voltages are applied is at least three for continuously transporting the wafer (6) and said voltage application is sequentially switched to a next electrode depending on the location of the wafer (6).

7. An apparatus according to any one of claims 1 to 5, characterized in that the number of said plane electrodes (1-1,...1-5) to which said voltages are applied is at least two for guiding the wafer (6) along said direction of transporting the wafer (6), said two plane electrodes being located so that a border line of said two plane electrodes' surfaces is along said direction.

8. An apparatus according to claim 7, characterized in that said border line of said two plane electrodes' surfaces is essentially along a center line of a course on which the wafer (6) is transported,
whereby the wafer (6) is transported along said border line by an inertia obtained at a previous stage where the wafer (6) is accelerated while the wafer (6) is prevented from being laterally deviated from said direction.

9. An apparatus according to claim 7, characterized in that said border line of said two plane electrodes' surfaces is deviated from a center line of a course on which the wafer (6) is transported where said course is curved, said deviation being toward an inner side of said curve, whereby a centrifugal force obtained from a speed of the wafer (6) at a previous stage is compensated so that the wafer (6) can trace a curved direction of said curved course.

10. An apparatus according to claim 6 characterized by third means (9, 10) for detecting the location of the wafer (6) with respect to said plane electrodes (1-1,...1-5), whereby said switching of voltage application to said electrodes (1-1,...1-5) is carried out according to said detected wafer (6) location.

11. An apparatus according to claim 10, characterized in that said third means comprises:
means for applying a radio frequency voltage between a particular pair of said plane electrodes; and
means for detecting a radio frequency current flowing into a particular one of said plane electrodes;
whereby an increase of said radio frequency current indicates an existence of the wafer (6) facing said particular electrodes (Fig. 18).

12. An apparatus according to claim 10, characterized in that said third means comprises:
light emitting means (9) located at one side of said wafer (6) to be transported, for emitting a light, and light detecting means (10) for detecting the light emitted from said light emitting means (9), said light detecting means (10) being located on an opposite side from said light emitting means (9) with respect of said wafer (6), said light emitting (9) and detecting means (10) being located so that said emitted light is allowed to be intercepted by said wafer (6).

## Patentansprüche

1. Vorrichtung zum Transportieren von blattförmigem Material in einer Horizontalrichtung, wobei diese Vorrichtung umfaßt:
eine Vielzahl von planen Elektroden (1-1, ..., 1-5), wobei eine jede dieser Elektroden eine plane Oberfläche hat und diese Oberflächen miteinander eine gemeinsame plane Fläche bilden und diese plane Oberfläche der Elektroden (1-1, ..., 1-5) dem besagten Material gegenüberliegend ausgerichtet ist, und
erste Mittel zum ausgewählten Anlegen einer elektrischen Spannung an wenigstens eine dieser Elektroden (1-4) und einer entgegengesetzten elektrischen Spannung an die anderen dieser Elektroden (1-1, 1-2, 1-3), wobei dies in Übereinstimmung mit einer vorgegebenen Folge erfolgt und somit eine Kraft auf das Material in Horizontalrichtung entsprechend dieser Kraft ausgeübt wird, wobei dieses Material horizontal transportiert wird,
gekennzeichnet dadurch,
- daß dieses Material eine Wafer-Scheibe (6) aus elektrisch leitfähigem Material ist,
- so daß diese leitfähige Wafer-Scheibe (6) durch die angelegten Spannungen auch in Vertikalrichtung auf die Elektroden hin angezogen wird, und
- daß zweite Mittel zum Blasen von Gas vorgesehen sind, um einen Luftspalt zwischen diesen Elektroden (1-1, ..., 1-5) und dieser Wafer-Scheibe (6) dadurch aufrechtzuerhalten, daß eine resultierende, auf dem Gewicht der leitfähigen Wafer-Scheibe beruhende vertikale Kraft und die durch die angelegten Spannungen verursachte vertikale Anziehung zu den Elektroden miteinander ausbalanciert sind.

2. Vorrichtung nach Anspruch 1, gekennzeichnet dadurch,
daß diese zweiten Mittel eine Vielzahl von Gasdüsen (7) umfassen, die durch die Oberfläche dieser planen Elektroden (1-1, ..., 1-5) hindurchgehen, und durch diese Düsen (7) das Gas senkrecht zur Wafer-Scheibe (6) herausgeblasen wird.

3. Vorrichtung nach Anspruch 2, gekennzeichnet dadurch,
daß das Gas ausgewählt ist aus einer Gruppe eines inerten Gases und reiner trockener Luft.

4. Vorrichtung nach einem der Ansprüche 1 bis 3, gekennzeichnet dadurch,
daß die Oberflächen dieser planen Elektroden (1-1, ..., 1-5) mit einer dielektrischen Schicht (2) bedeckt sind.

5. Vorrichtung nach einem der Ansprüche 1 bis 4, gekennzeichnet dadurch,
daß die an diese Elektroden (1-1, ..., 1-5) angelegten Spannungen Gleich-(Strom-)Spannungen sind.

6. Vorrichtung nach einem der Ansprüche 1 bis 5, gekennzeichnet dadurch,
daß die Anzahl der planen Elektroden (1-1, ..., 1-5), an die diese elektrischen Spannungen anzulegen sind, wenigstens gleich drei ist, um die Wafer-Scheibe (6) kontinuierlich transportieren zu können, und das Anlegen der elektrischen Spannung abhängig vom Ort der Wafer-Scheibe (6) zur nächsten Elektrode in Folge weitergeschaltet wird.

7. Vorrichtung nach einem der Ansprüche 1 bis 5, gekennzeichnet dadurch,
daß die Anzahl der planen Elektroden (1-1, ..., 1-5), an die diese Spannungen anzulegen sind, wenigstens gleich zwei beträgt, um die Wafer-Scheibe (6) entlang der Richtung des Transportierens der Wafer-Scheibe (6) zu führen, wobei diese zwei planen Elektroden derart positioniert sind, so daß eine begrenzende Linie dieser zwei planen Elektrodenoberflächen entlang dieser Richtung ausgerichtet ist.

8. Vorrichtung nach Anspruch 7, gekennzeichnet dadurch,
daß diese begrenzende Linie der zwei planen Elektrodenoberflächen im wesentlichen entlang einer Mittellinie eines Kursweges vorliegt, auf dem die Wafer-Scheibe (6) zu transportieren ist, wobei die Wafer-Scheibe (6) entlang dieser begrenzenden Linie infolge eines Trägheitsmoments transportiert wird, das in einem vorausgegangenen Stadium erhalten worden ist, in dem die Wafer-Scheibe (6) beschleunigt worden ist, wobei die Wafer-Scheibe (6) daran gehindert worden ist, seitlich von dieser Richtung abzuweichen.

9. Vorrichtung nach Anspruch 7, gekennzeichnet dadurch,
daß diese begrenzende Linie der zwei planen Elektrodenoberflächen von der Mittellinie eines Kursweges abweicht, auf dem die Wafer-Scheibe (6) transportiert wird, wobei dieser Kursweg gekrümmt ist, wobei diese Abweichung zur Innenseite dieser Krümmung ist, und wobei eine Zentrifugalkraft, die aus einer Geschwindigkeit der Wafer-Scheibe (6) zu einem vorausgegangenen Stadium erhalten ist, derart kompensiert ist, daß die Wafer-Scheibe (6) der gekrümmten Richtung dieses gekrümmten Weges folgen kann.

10. Vorrichtung nach Anspruch 6, gekennzeichnet durch
dritte Mittel (9, 10) zum Erfassen des Ortes der Wafer-Scheibe (6), bezogen auf die planen Elektroden (1-1, ..., 1-5), wobei das Schalten des Anlegens der Spannung an die Elektroden (1-1, ..., 1-5) entsprechend dem festgestellten Ort der Wafer-Scheibe (6) ausgeführt wird.

11. Vorrichtung nach Anspruch 10, gekennzeichnet dadurch,
daß diese dritten Mittel umfassen:
Mittel zum Anlegen einer (Rundfunk-)Hochfrequenzspannung zwischen einem speziellen Paar dieser planen Elektroden und
Mittel zum Feststellen eines (Rundfunk-)Hochfrequenzstromes, der in einer speziellen Elektrode dieser planen Elektroden fließt,
wobei ein Anstieg dieses Hochfrequenzstromes das Vorhandensein der Wafer-Scheibe (6), die dieser speziellen Elektrode gegenüberliegt, anzeigt (Figur 18).

12. Vorrichtung nach Anspruch 10, gekennzeichnet dadurch,
daß die dritten Mittel umfassen:
lichtaussendende Mittel (9), die auf einer Seite der zu transportierenden Wafer-Scheibe (6) positioniert sind, um Licht auszusenden, und
lichtdetektierende Mittel (10) zum Detektieren von von diesen lichtaussendenden Mitteln (9) ausgesandten Lichtes, wobei diese lichtdetektierenden Mittel (10), bezogen auf die Wafer-Scheibe (6), auf einer diesen lichtaussendenden Mitteln (9) gegenüberliegenden Seite positioniert sind, so daß die lichtaussendenden Mittel (9) und die lichtdetektierenden Mittel (10) derart positioniert sind, daß das ausgesandte Licht von der Wafer-Scheibe (6) unterbrochen werden kann.

## Revendications

1. Dispositif de transport d'un matériau en feuille suivant une direction horizontale, ledit dispositif comprenant :
une pluralité d'électrodes planes (1-1, ..., 1-5) dont chacune comporte une surface plane horizontalement coplanaire par rapport aux autres, ladite surface plane desdites électrodes (1-1, ..., 1-5) faisant face audit matériau ; et
un premier moyen pour appliquer de façon sélective une tension à au moins l'une desdites électrodes (1-4) et une tension opposée aux autres desdites électrodes (1-1, 1-2, 1-3) conformément à une séquence prédéterminée d'où ainsi l'exercice d'une force sur le matériau suivant la direction horizontale, force en relation avec laquelle ledit matériau est transporté horizontalement,
caractérisé en ce que :
ledit matériau est une plaquette de matériau électriquement conducteur (6),
de telle sorte que ladite plaquette conductrice (6) soit attirée par lesdites tensions appliquées aussi suivant une direction verticale en direction desdites électrodes, et
un second moyen est prévu pour insuffler du gaz afin de maintenir un espace d'air entre lesdites électrodes (1-1, ..., 1-5) et ladite plaquette (6) en équilibrant une force verticale résultante qui est due au poids de la plaquette conductrice et ladite attraction verticale en direction desdites électrodes provoquée par lesdites tensions appliquées.

2. Dispositif selon la revendication 1, caractérisé en ce que ledit second moyen comprend une pluralité de tuyères à gaz (7) installées au travers des surfaces desdites électrodes planes (1-1, ..., 1-5), le gaz étant insufflé au travers desdites tuyères (7) perpendiculairement en direction de la plaquette (6).

3. Dispositif selon la revendication 2, caractérisé en ce que ledit gaz est choisi parmi un groupe qui comprend un gaz inerte et un air sec propre.

4. Dispositif selon l'une quelconque des revendications 1 à 3, caractérisé en ce que lesdites surfaces desdites électrodes planes (1-1, ..., 1-5) sont recouvertes par une couche diélectrique (2).

5. Dispositif selon l'une quelconque des revendications 1 à 4, caractérisé en ce que lesdites tensions appliquées auxdites électrodes (1-1, ..., 1-5) sont des tensions continues.

6. Dispositif selon l'une quelconque des revendications 1 à 5, caractérisé en ce que le nombre desdites électrodes planes (1-1, ..., 1-5) auxquelles lesdites tensions sont appliquées est au moins égal à trois pour transporter en continu la plaquette (6) et ladite application de tension est commutée séquentiellement à une électrode suivante en fonction de l'emplacement de la plaquette (6).

7. Dispositif selon l'une quelconque des revendications 1 à 5, caractérisé en ce que le nombre desdites électrodes planes (1-1, ..., 1-5) auxquelles lesdites tensions sont appliquées est au moins égal à deux pour guider la plaquette (6) suivant ladite direction de transport de la plaquette (6), les deux dites électrodes planes étant positionnées de telle sorte qu'une ligne frontière des surfaces des deux dites électrodes planes soit orientée selon ladite direction.

8. Dispositif selon la revendication 7, caractérisé en ce que ladite ligne frontière desdites surfaces des deux dites électrodes planes est essentiellement orientée selon une ligne centrale d'une course suivant laquelle la plaquette (6) est transportée,
d'où il résulte que la plaquette (6) est transportée suivant ladite ligne frontière au moyen d'une inertie obtenue au niveau d'un étage précédent où la plaquette (6) est accélérée tandis que la plaquette (6) est empêchée d'être déviée latéralement par rapport à ladite direction.

9. Dispositif selon la revendication 7, caractérisé en ce que ladite ligne frontière desdites surfaces des deux dites électrodes planes est déviée par rapport à une ligne centrale d'une course suivant laquelle la plaquette (6) est transportée lorsque ladite course est incurvée, ladite déviation se formant en direction d'un côté interne de ladite courbe d'où il résulte qu'une force centrifuge obtenue à partir d'une vitesse de la plaquette (6) au niveau d'un étage précédent est compensée de telle sorte que la plaquette (6) puisse suivre une direction incurvée de ladite course incurvée.

10. Dispositif selon la revendication 6, caractérisé par un troisième moyen (9, 10) pour détecter l'emplacement de la plaquette (6) par rapport auxdites électrodes planes (1-1, ..., 1-5), d'où il résulte que ladite commutation d'une application de tension auxdites électrodes (1-1, ..., 1-5) est mise en oeuvre en relation avec ledit emplacement détecté de la plaquette (6).

11. Dispositif selon la revendication 10, caractérisé en ce que ledit troisième moyen comprend :
un moyen pour appliquer une tension haute fréquence entre une paire particulière desdites électrodes planes ; et
un moyen pour détecter un courant haute fréquence circulant à l'intérieur de l'une particulière desdites électrodes planes,
d'où il résulte qu'une augmentation dudit courant haute fréquence indique que la plaquette (6) est dans une position telle qu'elle fait face auxdites électrodes particulières (figure 18).

12. Dispositif selon la revendication 10, caractérisé en ce que ledit troisième moyen comprend :
un moyen émetteur de lumière (9) situé au niveau d'un côté de ladite plaquette (6) qui doit être transportée pour émettre une lumière et un moyen de détection de lumière (10) pour détecter la lumière émise depuis ledit moyen émetteur de lumière (9), ledit moyen de détection de lumière (10) étant positionné sur un côté opposé audit moyen émetteur de lumière (9) par rapport à ladite plaquette (6), ledit moyen émetteur de lumière (9) et ledit moyen de détection de lumière (10) étant positionnés de telle sorte que ladite lumière émise puisse être interceptée par ladite plaquette (6).
